## Europäisches Patentamt

## European Patent Office

## Office européen des brevets

(11) Publication number: **0 049 520**
**B1**

(12) **EUROPEAN PATENT SPECIFICATION**

(45) Date of publication of patent specification: **04.06.86**

(51) Int. Cl.⁴: **G 01 R 21/06**

(21) Application number: **81107995.3**

(22) Date of filing: **06.10.81**

(54) **Electronic watt/var transducer.**

(30) Priority: **06.10.80 US 194195**

(43) Date of publication of application:
**14.04.82 Bulletin 82/15**

(45) Publication of the grant of the patent:
**04.06.86 Bulletin 86/23**

(84) Designated Contracting States:
**DE FR GB IT**

(56) References cited:
**CH-A- 491 391**
**DE-A-2 530 374**
**DE-B-1 437 900**
**DE-B-1 922 453**
**DE-B-2 316 709**
**GB-A-1 202 465**
**US-A-3 551 847**
**US-A-3 794 917**
**US-A-3 947 763**
**US-A-3 950 706**
**US-A-4 027 241**
**US-A-4 055 803**
**US-A-4 055 804**

(73) Proprietor: **SQUARE D COMPANY**
**Executive Plaza**
**Palatine, IL 60067 (US)**

(72) Inventor: **Moore, Prentice G.**
**3053 Cascade Drive**
**Clearwater Florida 33519 (US)**

(74) Representative: **Baillie, Iain Cameron et al**
**c/o Ladas & Parry Isartorplatz 5**
**D-8000 München 2 (DE)**

(56) References cited:
**US-A-4 066 960**
**US-A-4 118 787**
**US-A-4 182 983**
**US-A-4 275 349**

Courier Press, Leamington Spa, England.

EP 0 049 520 B1

## Description

Background of the invention

Centralized supervision and control of today's complex electric power systems has created the need for devices capable of converting the significant AC power system quantities into accurate proportional signals that can be easily transmitted, recorded and fed into data acquisition systems. These signals can also be used for process control where, for example, the power consumed is directly proportional to motor torque. For measurement of the main quantity, AC power, various watt transducers have been developed. A watt transducer converts AC watts into a DC current which is directly proportional to AC watts. It is a common misconception to assume that watt and var transducers sense power. This is not true. These devices sense voltage and current and subsquently compute power from those quantities. There are various methods of effecting that computation; the time division multiplication, perhaps more accurately termed pulse width-pulse height multiplication method is perhaps the most accurate contemporary analog multiplication technique. The theory of this power computation method is based upon the principle that one input signal controls the width or duty cycle of a pulse train while a second input signal controls the amplitude of that pulse train. After the width and amplitude of the pulse train have been controlled (modulated) by the two input signals, the pulse train then passes through a low pass filter which retains only the DC component of the pulse train. Since the area of a rectangle is length×width, the resulting DC output voltage is therefore proportional to the product of the two input signals.

Of paramount importance in devices of this type is stability and accuracy of the performance of the device over changes in temperature and passage of time. The height of the triangular wave at the output of the triangular wave generator directly effects the stability of the overall performance of the device. The amplitude of this triangular wave must be extremely stable or the accuracy of the transducer will drift with temperature or over the passage of time. The amplitude of the triangular wave is, in turn, directly proportional to the amplitude of the squarewave input signal to the integrator within the triangular wave generator. Such squarewave inputs are traditionally produced by an output from a comparator in a feedback loop. The output of such a comparator essentially switches between its two supply voltages, which arrangement suffers from two problems: (1) The output circuit of the comparator often drifts with temperature changes; and, (2) Since the comparator switches between two supply voltages, it is necessary that the supply voltages themselves be very stable with changes in temperature and over passages of time.

A known type of transducer is disclosed in US—A—4027241. This document discloses a transducer having a current input circuit and a voltage input circuit each of which produces a signal representative of these variables. The voltage representative signal is then combined with a triangular wave to produce a pulse width modulated signal. The pulse width modulated signal is then combined with the current representative signal to produce a pulse train in which the width of the pulses is proportional to the sensed voltage and the height of which is proportional to the sensed current. This signal is then filtered to remove the AC component due to the pulse nature of the signal to derive an output representing the product of the sensed voltage and current. In the arrangement of United States Patent 4027241 the triangular wave is derived by integration of a squarewave. The squarewave is produced by a circuit including a comparator contained in a feedback loop. The amplitude of the triangular wave can be adjusted by means of a variable resistor in this feedback loop.

US—A—4055804 concerns a watt-watt/hour meter where a current proportional to instantaneous power is obtained from a current voltage multiplier circuit and is maintained as a current signal through amplifying and filtering, and through the watt output load. The watt output amplifier is a current input, current output amplifier which simultaneously functions as an active ripple filter. It directly couples the input signal to the inverting input and capacitively couples the input ripple to the non-inverting input of the amplifier's op-amp. The output load, which is externally connected between the inverting input and the output of the op-amp, does not have a common with the internal ground and effectively floats with the ripple.

The above arrangements, particularly that of US—A—4027241, are likely to suffer from the defects set out above. An object of this invention is to provide a power monitoring transducer of the type using pulse width and pulse height modulators in which the output of the triangular wave generator is more stable.

According to the present invention there is provided a tranducer for monitoring power in a power line, said tranducer including current input means for producing a current-representative signal proportional to the instantaneous current in the power line; voltage input means for producing a voltage-representative signal proportional to the instantaneous voltage on the power line; multiplier means connected to said current input means and said voltage input means for receiving said voltage representative signal and said current-representative signal, the multiplier means including triangular wave generating means squarewave generator for producing a square waveform signal output on an output line and including comparator means, resistive feedback means connecting said output line of said squarewave generating means to an input of the comparator means; integrator means connected to the output line of the squarewave generating means for producing a triangular wave signal, pulse width modulator corrected to the triangular wave generating means for combining said triangular wave signal with the voltage-representaive signal, to produce a pulse train in which pulse width depends on the magnitude of the voltage representative signal, a pulse height modulator means connected to said pulse width modulator for modulating said pulse train by the current-representative signal so that the height of the pulses in said pulse train depends on the current-representative signal; thereby producing a pulse train in which pulse area represents the power in the line; filter and amplifying means connected to the multiplier means for filtering out alternating current components of the pulse train produced by the pulse height modulator and integrating and amplifying the remaining direct current component thereof thereby producing a signal which is directly proportional to the instantaneous power in the power line; characterised in that the squarewave generator includes means for generating a first and a second reference voltages, an electronic switch connected to be actuated by the output of the comparator means to switch said output line between the first or the second reference voltages, and there is provided amplifier means connected to the output of the integrator means, said amplifier means having an input and a feedback means, wherein the gain of said amplifier means is adjusted by connecting the output of said amplifier means to one of a number of points in a resistive means contained in said feedback means of said amplifier means. Optional features of the invention are set out in claims 2—4.

Another problem encountered with watt transducers of the pulse width-pulse height modulation multiplication type is the adjustment of the sensitivity of the transducer for various configurations used in power monitoring, such as 1, 2, and 3 element power monitoring. If one designs a one-element, single phase transducer to produce an output of one milliamp at 500 watts (a standard output recognized in industry), then for a three-phase, four-wire, three-element transducer, one must adjust the sensitivity of each of the three elements since they are summed, to one-third of their one-element value in order to produce the same output current when the transducer sees a total of 1500 watts (500 watts per element). If this were not accomplished, the transducer would produce three times the output current for a three-element application as it would for a one-element application. The heretofore unsolved problem has been determining exactly where to adjust the sensitivity of each element in order to produce one-third of the output when three times the input is present.

The invention, by providing gain adjustment in the amplifier means following the integrator means enables very simple adjustment to various multi-element applications without sacrificing stability or accuracy and without expensive re- designing of circuitry or re-working in a manufacturing facility.

Still another problem with power monitoring transducers is that they are difficult to calibrate and maintain after their installation. Equipment which is capable of controlling all three factors involved in computation of power (voltage, current and power factor) is expensive to produce and difficult to operate except within a highly controlled environment, such as a calibration laboratory. Further, transducers of this type presently available are complexly configured and generally must be returned to the manufacturer for repair.

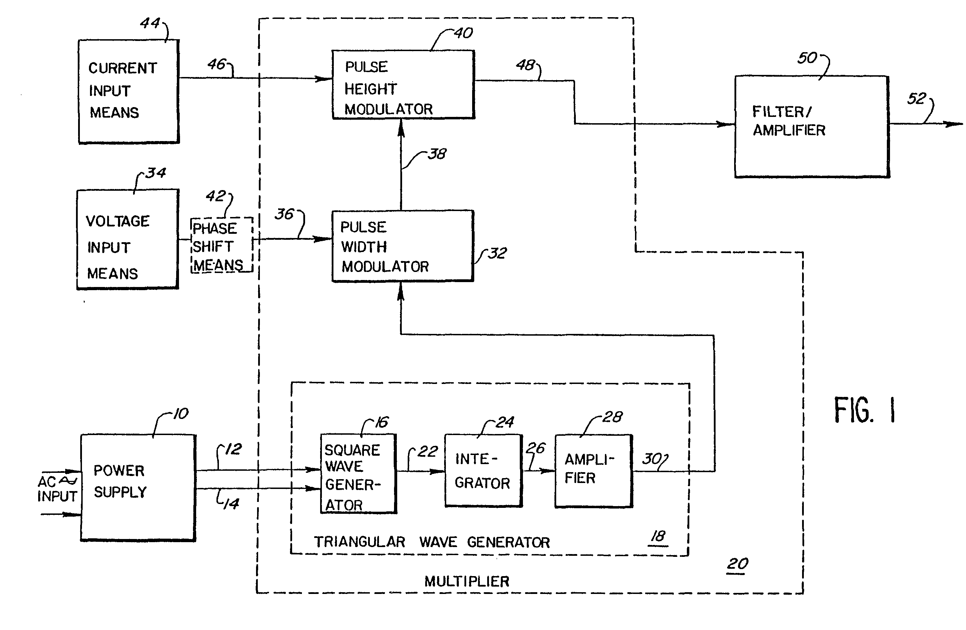

Calibration of a transducer embodying the invention and applied to an alternating current line is simplified by the fact that the transducer can very simply be made responsive to a steady DC voltage and direct current. This considerably simplifies calibration of the transducer. Equipment embodying the invention is also readily constructable such that an installed transducer can easily be repaired by the insertion of pre-calibrated circuit boards with no sacrifice in stability, accuracy of the device or equipment down-time. An embodiment of the invention will now be described making reference to the accompanying drawings in which: figure 1 is a block diagram of a complete watt/var transducer.

Fig. 2(a—g) is a representation of various waveforms present at locations within the transducer under different conditions.

Fig. 3 is a schematic diagram representing the improved squarewave generator within the triangular wave generator of the transducer.

Fig. 4 is a schematic diagram representing the improved integrator of the triangular wave generator of the transducer.

Fig. 5 is a schematic diagram representing the improved amplifier of the triangular wave generator of the transducer.

Fig. 6 is a schematic diagram of the pulse width modulator and the improved pulse height modulator of the transducer.

In describing the preferred embodiment of the invention illustrated in the drawings, specific terminology will be resorted to for the sake of clarity. However, the invention is not intended to be limited to these specific terms so selected and it is to be understood that each specific term contains all technical equivalents which operate in a similar manner to accomplish a similar purpose. For example, the terms "connected" or "coupled", may include connection through other circuit elements wherein such connection is recognized as equivalent and operates in essentially the same manner to accomplish the same purpose.

Detailed description

A watt transducer is a device for sensing the voltage and current in a power line and multiplying that voltage and current to obtain a watt output signal proportional to the power present in the power line monitored by the transducer. Watt transducers measure what is known as active power, which is calculated by multiplying voltage×current×the cosine of the phase angle between the voltage and current. This quantity, cosine of the phase angle, is known as power factor, and, in purely resistive loads, the phase angle is zero, thereby rendering the power factor (cosine of the phase angle) equal to a value of one.

A var transducer is a device for sensing the voltage and reactive current in a power line. Reactive current, that current necessary to establish the magnetic field on inductive loads, is sometimes known as magnetizing current. A var transducer multiplies the voltage and reactive current quantities×the sine of the phase angle between those two quantities to produce a watt output signal proportional to the reactive power in the power line being monitored by the var transducer. Since the sine of an angle is equal to the cosine of 90 degrees minus that angle, by shifting the voltage input from a power line by 90 degrees, one can use the circuitry of a watt transducer to measure reactive power in that power line.

Fig. 1 is a block diagram of the basic components of a watt/var transducer. Although Fig. 1 embodies the present invention, Fig. 1 is so simplified that it differs very little from similar prior art.

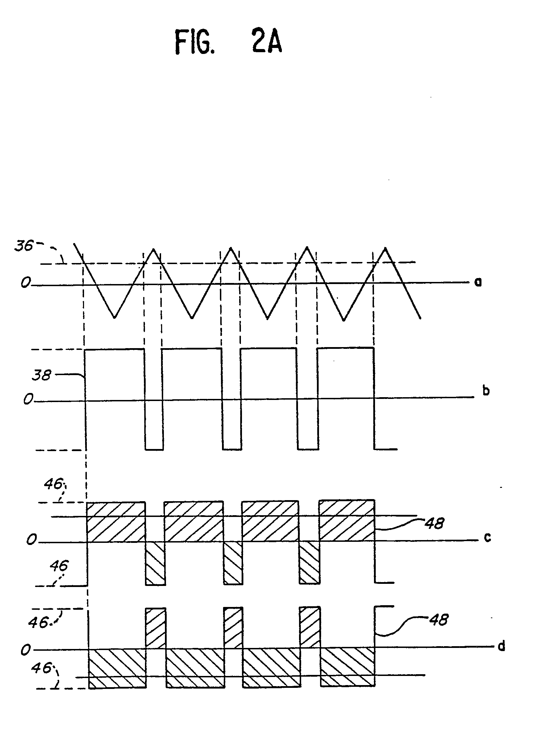

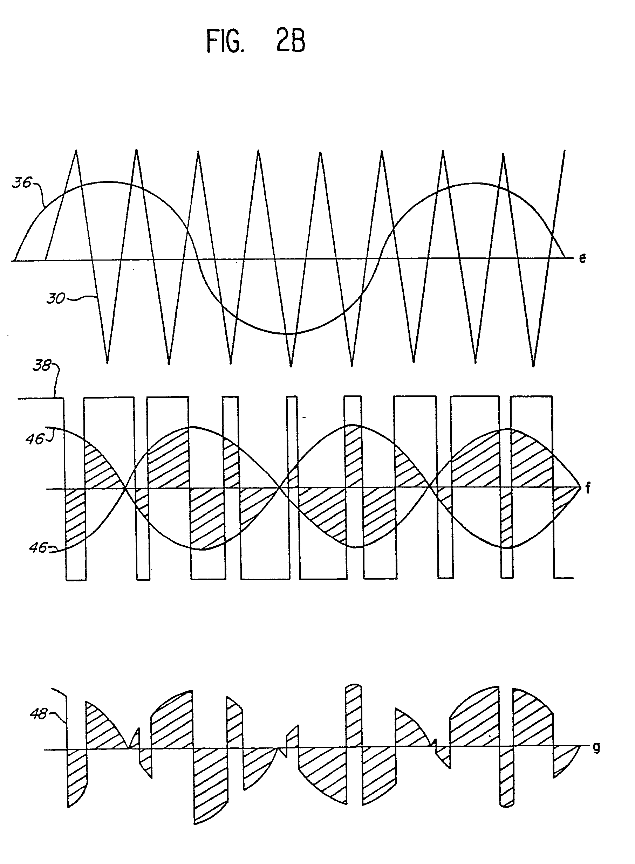

Referring to Fig. 1, a power supply 10 provides various operating voltages, represented by 12 and 14, to various components within the transducer including a squarewave generator 16 within a triangular wave generator 18 which comprises a portion of a multiplier 20. The power supply 10 is of a very stable type well-known in the art. The squarewave generator 16 produces a squarewave output 22 to an integrator 24 which is a portion of the triangular generator 18 in the multiplier 20. The integrator 24 integrates the squarewave output 22 over time to produce a triangular waveform output 26 to an amplifier 28 of the triangular wave generator 18 within the multiplier 20. The amplifier 28 amplifies the triangular waveform output 26 to produce a triangular wave output 30 of precise amplitude. The waveform of the triangular wave output 30 is shown in Fig. 2-a.

The triangular wave output 30 is the output provided by the triangular wave generator 18 to a pulse width modulator 32. Voltage input means 34 of a type commonly known in the art monitor the power line, not shown, and produce a voltage representative signal 36 which is directly proportional to the instantaneous voltage present on the power line. This voltage representative signal 36 is the second input to the pulse width modulator 32 and is the modulating signal by which the pulse width modulator 32 modulates the triangular wave 30 to produce a pulse width modulated signal 38, shown in Fig. 2-b, to a pulse height modulator 40. The above-described relationship between the voltage input means 34 and the pulse width modulator 32 reflects the circuitry of a watt transducer. Should it be desired to monitor and represent reactive power, one may simply insert a phase shifter 42 in the circuit between the voltage input means 34 and the pulse width modulator 32. The purpose of the phase shifter 42 is to shift the output of the voltage input means 34 by 90 degrees to enable one to simulate measurement of the sine of the phase angle between the current and the voltage on the power line by actually measuring 90 degrees minus the cosine of that phase angle thereby achieving the capability of measuring the parameters necessary for the transducer to compute reactive power and produce a signal proportional thereto. Current input means 44 of a type commonly known in the art are employed to monitor the current present in the power line, not shown, and produce a current representative signal 46 which is directly proportional to the instantaneous current present on the power line. This current representative signal 46 comprises the second input to the pulse height modulator 40. The pulse height modulator 40 applies the pulse width modulated signal 38 as the modulating input to modulate the current representative signal 46 thereby producing a pulse width-pulse height modulated signal 48 which is identical in frequency to the pulse width modulated signal 38 but whose amplitude is equal to the amplitude of the current representative signal 46. The waveform of the pulse width-pulse height modulated signal 48 is shown in Fig. 2-c. As can be understood by one skilled in the art, this technique can be used to multiply two DC signals in all four quandrants; that is, all combinations of positive and negative voltage representative signals 36 and current representative signals 46, an example of the effect of which may be seen by comparing Figs. 2-c and 2-d. The pulse width-pulse height modulated signal 48 is provided as the input to a filter/amplifier 50. The filter/amplifier 50 filters out alternating current components of the pulse width-pulse height modulated signal 48 and amplifies the remaining direct current components of that signal to produce a direct current transducer output signal 52 which is directly proportional to the instantaneous power in the power line.

The foregoing explanation presumes that the voltage representative signal 36 and the current representative signal 46 are direct current signals. The present watt transducer is capable of operating with alternating voltage representative signals 36 and alternating current representative signals 46. So long as the triangular wave output 30 is of a high frequency relative to the voltage representative signal 36 and the current representative signal 46, there can be ample sampling of the voltage and current on the power line to give an accurate representation of the power thereon. Fig. 2-e through 2-g illustrate the waveforms associated with the operation of this transducer with alternating input values 36 and 46. In Fig. 2-e, there appears a triangular wave 30 similar to Fig. 2-b and superimposed thereupon is an alternating waveform representative of the voltage representative signal 36. Fig. 2-f illustrates the pulse width modulated signal 38 comparable to Fig. 2-c for the direct current case. Superimposed thereupon are "mirror" waveforms indicating the operation of the pulse height modulator 40 upon an alternating current representative signal 46. Fig. 2-g is a recreation of the shaded areas contained in Fig. 2-f to clearly illustrate the resulting waveform of the pulse width-pulse height modulated signal 48 in the situation involving alternating input signals 36 and 46.

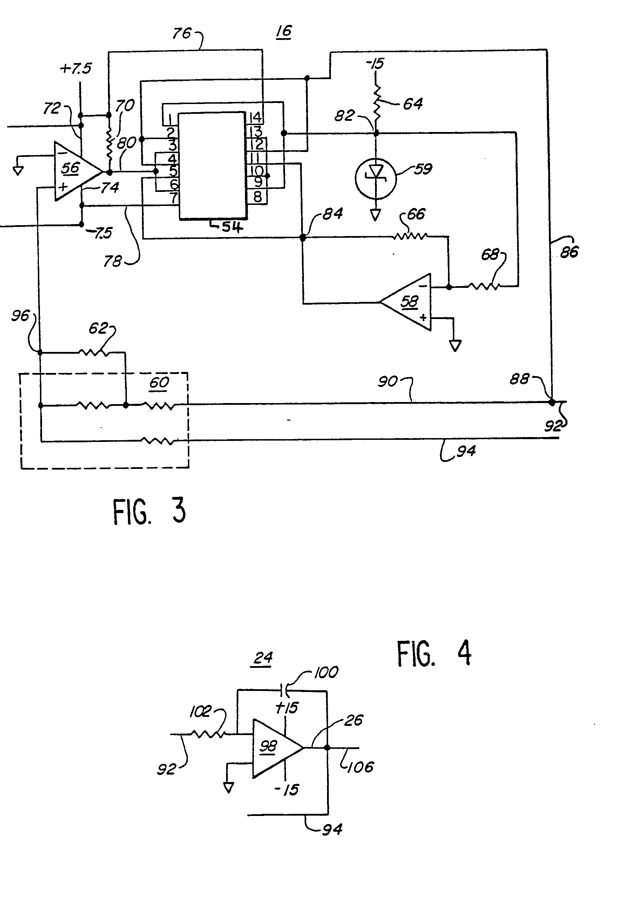

Referring to Fig. 3, the squarewave generator 16 is comprised of a comparator 56, a COS/MOS dual-complementary pair plus inverter 54, an operational amplifier (op-amp) 58, a thin film resistor network of high stability 60, resistors 62, 64, 66 and 68, and a pull-up resistor 70. The power supply 10 provides direct current operating voltages at a positive DC power supply input 72 and a negative DC power supply input 74 of the comparator 56. The positive DC power supply input 72 is electrically connected to the COS/MOS inverter 54 by an electrical line 76 thereby providing a similar operating voltage to COS/MOS inverter 54. Additionally, the negative DC power supply input 74 is electrically connected to the COS/MOS inverter 54 by an electrical line 78 thereby providing a similar negative operating voltage to the COS/MOS inverter 54. The pull-up resistor 70 is interconnected between a comparator output 80 and electrical line 76. The COS/MOS inverter 54 is situated in the squarewave generator circuit 16 in a manner allowing it to operate as a single pole, double throw electronic switch.

The power supply 10 also supplies an operating voltage to one end of the resistor 64. The other end of the resistor 64 is electrically connected to the COS/MOS inverter 54, the Zener diode 59 and the op-amp 58 through the resistor 68. The op-amp 58 and the resistor 66 are connected in a manner allowing the op-amp 58 to operate as a unity gain inverter. Thus, the Zener diode 59 creates a negative reference voltage at point 82 in the squarewave generator 16 and the op-amp 58 and resistor 66, operating as a unity gain inverter, provide a positive reference voltage, equal in amplitude but opposite in sign to the negative reference voltage, at point 84 in the squarewave generator 16. Output from the squarewave generator 16 to the integrator 24 of the triangular wave generator 18 is provided along electrical line 86. At a junction 88 in the squarewave generator 16, the output signal to the integrator 24 carried on electrical line 86 is split; a portion of that signal is carried to the integrator 24 along electrical line 92 and another portion of that signal is carried along electrical line 90 back to the comparator 56 via a portion of the thin film resistor network 60 and resistor 62. Feedback, in the form of a triangular wave, from the output of the integrator 24 is provided along electrical line 94 via a portion of the thin film resistor network 60 to the same terminal of the comparator 56 to which the electrical line 90 is connected.

Operation of the squarewave generator 16 is as follows: The COS/MOS inverter 54, operating as a single pole, double throw electronic switch, operates to select as an output along electrical line 86 either the negative reference voltage present at point 82 or the positive reference voltage present at point 84. The positioning of the COS/MOS inverter operating as an electronic switch to choose between those two reference voltages is determined by the output 80 of the comparator 56. The pull-up resistor 70 enables the comparator 56 to provide both positive and negative operating signals to the COS/MOS inverter 54 thereby ensuring its operation as an electronic single pole, double throw switch. The portion of the electrical signal carried on line 86 which is returned to the comparator 56 by electrical line 90 is summed with the triangular wave feedback from the output of the integrator 24, which summing is accomplished by the common connection of electrical line 90 and electrical line 94 at junction 96 in the squarewave generator 16. Since the signal carried on electrical line 90 is a squarewave signal, its summing with the triangular wave signal on electrical line 94 will result in an electrical signal provided to the comparator 56 with zero-crossing characteristics which will cause comparator 56 to shift its output 80 to the COS/MOS inverter 54 from positive to negative or from negative to positive, thereby causing the COS/MOS inverter 54, operating as a single pole, double throw electronic switch, to change its state so that where one of the reference voltages had previously been present on electrical line 86, now the other reference voltage will now be present along electrical line 86. Thus, the comparator 56 is not used in this circuit to provide the squarewave output to the integrator 24, but is merely used to provide triggering voltages to the COS/MOS inverter 54 operating as a single pole, double throw electronic switch. It is the COS/MOS inverter 54 which produces the squarewave output to the integrator 24 by, in response to the triggering voltages provided by the output 80 of the comparator 56, switching between the negative reference voltage present at point 82 and the positive reference voltage present at point 84, and applying each of those reference voltages, in turn, as output to the integrator 24 along electrical lines 86 and 92. That output is in the form of a squarewave, the peak values of which will correspond to the reference voltages present at points 82 and 84 in the squarewave generator 16.

Referring to Fig. 4, the integrator 24 is comprised of an operational amplifier (op-amp) 98, a capacitor 100 and an input resistor 102. The op-amp 98, in conjunction with the capacitor 100, operates as an integrating circuit which integrates with respect to time the input signal received from the squarewave generator 16 by electrical line 92 through input resistor 102. The triangular waveform output 26 of the op-amp 98 is provided to the amplifier 28 by electrical line 106 and is fed back to the squarewave generator 16 by electrical line 94. Since the COS/MOS inverter 54 chages slightly in resistance with changes in temperature, it is best that the input resistor 102 be very high in resistance with respect to the resistance of the COS/MOS inverter 54; resistances on the order of 75k ohms have been found to be appropriate. Establishing the resistance of input resistor 102 at such a relatively high level serves to render any instability attributable to changes in the resistance of the COS/MOS inverter 54 inconsequential, thereby ensuring a high degree of stability of the triangular waveform output 26 of the op-amp 98.

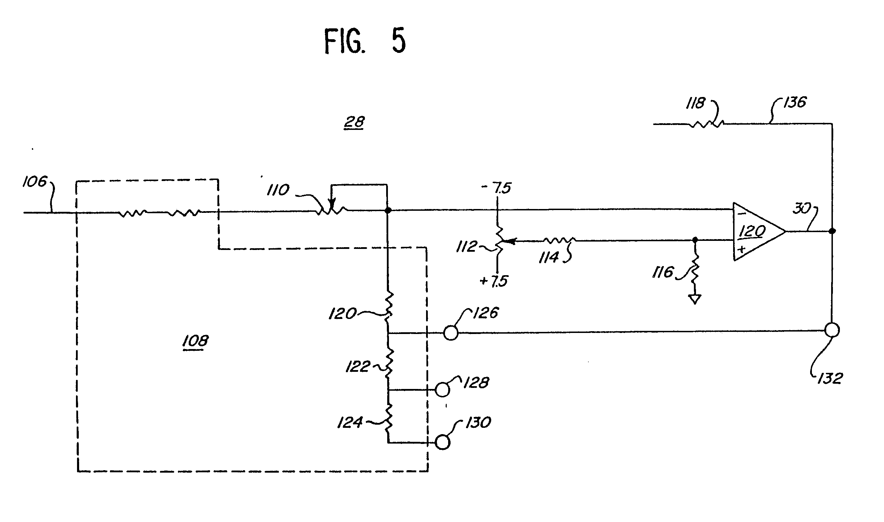

Referring to Fig. 5, the amplifier 28 of the traingular wave generator 18 is comprised of a thim film resistor network 108 with a very low tracking error, variable resistors 110 and 112, resistors 114, 116 and 118, and an operational amplifier (op-amp) 120. The op-amp 120 is connected with a portion of the thin film resistor network 108 in a manner by which it operates as a signal amplifier. Variable resistors 110 and 112 allow calibration of the amplifier 28.

Watt and var transducers are used to provide signals indicative of the active and reactive power, respectively, present in power lines. These transducers' outputs are used to drive instruments or to provide feedback indications to control devices in industrial processes and in similar applications. Industry standards have been established whereby the instruments, control circuits and the like are designed to respond to transducer output signals of a specified standard amplitude. This industry standary is generally set at one milliamp at 500 watts. Accordingly, regardless of how many phases or elements of a power line are monitored by a transducer, the output of that transducer must be produced at the industry's standary level in order that instruments, control circuits and the like responding to that transducer output signal can operate accurately and reliably. For instance, if a single phase or element designed transducer is used to monitor a three-element power line, its output would be on the order of 1500 watts, or three times the industry standard. This circuit provides a simple way to adjust the sensitivity of the transducer to accommodate multi-phase power monitoring applications. The sensitivity of the multiplier circuit in a transducer is inversely proportional to the height of the triangular wave provided to the pulse width and pulse height modulating portions. Therefore, by increasing the amplitude of the triangular wave by a factor of three, the circuit will have one-third the sensitivity that it had at its original amplitude. This adjustment of triangular wave amplitude is accomplished in this invention in the amplifier 28 of the triangular wave generator 18. The gain of the amplifier 28 is determined by the resistance in the feedback of the op-amp 120. This resistance in this invention is provided by resistors 120, 122 and 124 of the thin film resistor network 108. The resistors 120, 122 and 124 are all of equal resistance value. Therefore, through the very simple means of connecting a terminal 132 to various terminals 126, 128 and 130, one may very simply and inexpensively vary the feedback resistance of the op-amp 120 in equal increments, thereby "Programming" the amplitude of the traingular wave output 30 of the op-amp 120 provided to the pulse width modulator 32 along electrical line 136 through a resistor 118. By this method, connection of terminals 132 and 126 accommodates a one-element transducer application. Similarly, connection of terminals 132 and 128 accommodate two-element applications, and connection of terminals 132 and 130 accommodate three-element applications.

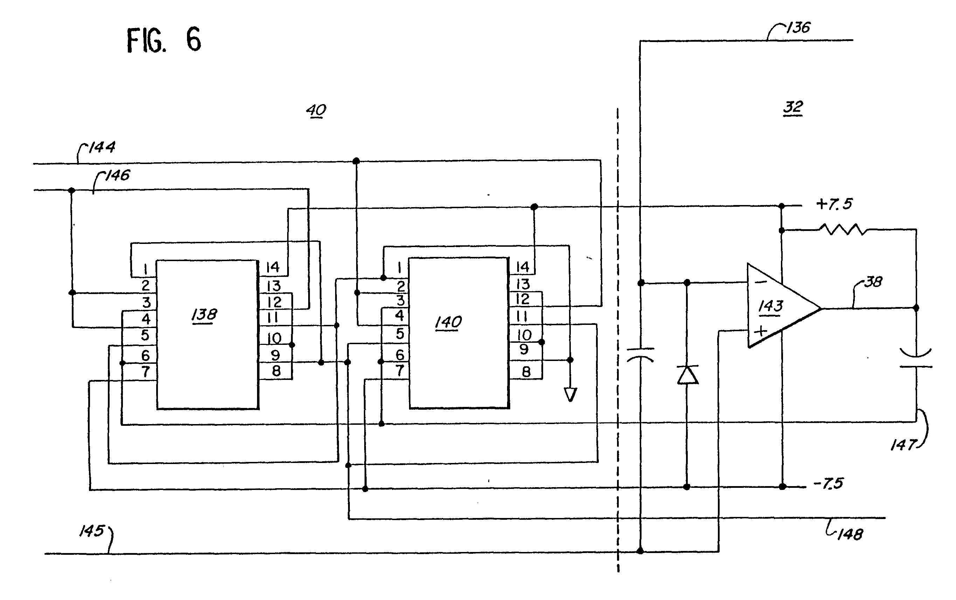

Referring to Fig. 6, an electrical line 136 carrying the triangular wave output 30 of amplifier 28 of the triangular wave generator 18 provides input to a pulse width modulator 32 of a type well-known in the art. The details of pulse width modulator 32 are illustrated in Fig. 6 merely to illustrate its interconnection and interaction with the pulse height modulator 40 wherein the movelty of this invention lies. The pulse width modulator receives the voltage representative signal 36 by an electrical line 145 which is connected to a comparator 143. The triangular wave output 30 of amplifier 28 of the triangular wave generator 18 is also provided to comparator 143 by electrical line 136. The behavior of the comparator 143 when the summation of voltage representative signal 36 and triangular wave output 30 creates zero-crossing situations serves to pulse width modulate the voltage representative signal 36 by the triangular wave output 30 to produce the pulse width modulated signal 38, shown in Fig. 2-b. This pulse width modulated signal is provided to the pulse height modulator 40 by electrical line 147.

The pulse height modulator 40 is comprised of two COS/MOS dual-complementary pair plus inverters 138 and 140 interconnected in a manner whereby they operate as a unit as an electronic double pole, double throw switch. Previous devices of this kind have utilized single pole, double throw switches in the pulse height modulating function. Referring to Fig. 2, one may see the importance of the application of a double pole, double throw switch in this pulse height modulating function. At Fig. 2-a, the voltage representative signal of 36 is applied to the triangular wave output 30 of the amplifier 28 of the triangular wave generator 18 by the pulse width modulator 32. The pulse width modulated signal 38 of the pulse width modulator 32 is shown in Fig. 2-b. The pulse height modulator 40 then modulates the current representative signal 46 introduced to the pulse height modulator 40 by a current input signal line 144 and a current input signal line 146. The current representative signal 46 is modulated by the pulse width modulated signal 38 of the pulse width modulator 32 to produce the pulse width pulse height modulated signal 48 illustrated in Fig. 2-c. The significant aspect of Fig. 2-c is that waveforms below the zero voltage line are not disregarded but rather are included in the pulse width pulse height modulated signal 48 of the pulse height modulator 40 for later integration by the filter/amplifier 50 to produce the transducer output signal 52. It is the application of a double pole, double throw switch to effect the pulse height modulation function that allows inclusion of portions of the pulse width pulse height modulated signal 48 below the zero voltage line in the integration process of the filter/amplifier 50, thereby ensuring greater accuracy of the transducer output signal 52 than would be attainable by only integrating those portions of the pulse width pulse height modulated signal 48 above the zero-voltage line illustrated in Fig. 2-c, as is the case when a single pole, double throw switch effects pulse height modulation. Figs. 2e—g illustrate alternating signal applications corresponding respectively to Figs. 2a—c, which depicted DC signal applications.

Referring once again to Fig. 6, the interconnection of the COS/MOS inverters 138 and 140 in order that they may operate as a unit as an electronic double pole, double throw switch is accomplished by connecting pin numbers as indicated in the following tables:

TABLE 1

| | Connected to | |
|---|---|---|
| 138 Pin No. | 138 Pin No. | 140 Pin No. |
| 1 | 9 | 5, 11 |
| 2 | 4, 12 | — |
| 3 | 6 | 3, 6 |
| 4 | 2, 12 | — |
| 5 | 11 | 1, 9 |
| 6 | 3 | 3, 6 |
| 7 | — | 7 |
| 8 | 10, 13 | — |
| 9 | 1 | 5, 11 |
| 10 | 8, 13 | — |
| 11 | 5 | 1, 9 |
| 12 | 2, 4 | — |
| 13 | 8, 10 | — |
| 14 | — | 14 |

TABLE 2

| | Connected to | |
|---|---|---|
| 140 Pin No. | 140 Pin No. | 138 Pin No. |
| 1 | 9 | 5, 11 |
| 2 | 4, 12 | — |
| 3 | 6 | 3, 6 |
| 4 | 2, 12 | — |
| 5 | 11 | 1, 9 |
| 6 | 3 | 3, 6 |
| 7 | — | 7 |
| 8 | 10, 13 | — |
| 9 | 1 | 5, 11 |
| 10 | 8, 13 | — |
| 11 | 5 | 1, 9 |
| 12 | 2, 4 | — |
| 13 | 8, 10 | — |
| 14 | — | 14 |

The pulse width pulse height modulated signal 48 of the pulse height modulator 40 is supplied to the filter/amplifier 50 via electrical line 148. The filter/amplifier 50 is of a type well-known in the art and serves to filter out alternating current components of the output of the pulse height modulator 40 and integrate and amplify the remaining direct current component of that output to produce a direct current transducer output signal 52 which is directly proportional to the instantaneous power in the power line monitored by the transducer.

It is of importance to note that this invention monitors and multiplies DC voltage representative signals 36 and current representative signals 46. Applications of this invention to AC circuits is accomplished by ensuring the triangular wave output 30 of the amplifier 28 of the triangular wave generator 18 is of high frequency relative to the frequency of the voltage representative signal 36 and the current representative signal 46. Figs 2e—g illustrate the application of alternating input signals to this invention. If the triangular wave output 30 of the amplifier 28 of the triangular wave generator 18 is of sufficiently high frequency relative to the frequency of the voltage representative signal 36 and the current representative signal 46, then those portions "sampled" by the pulse width modulator 32 and the pulse height modulator 40 (that is, those areas crosshatched in Figs. 2f and 2g) will appear to the transducer as short segments of DC signals and will be treated as such by the transducer. The significance of this fact is that this transducer can therefore be calibrated with DC signals, a process which is much more easily accomplished than is calibration of such a device with AC signals. This is because computation of power associated with AC signals involves three factors: voltage, current and power factor. However, computation of power associated with DC signals involves only two factors: voltage and current. Therefore, simpler, cheaper and more accurate calibration is attainable by calibration with DC signals than is attainable with calibration by AC signals. Additionally, this facilitates pre-calibration of multiplier components prior to shipment to field locations, so that devices installed in the field can be easily repaired by insertion of pre-calibrated circuitboards on site with no sacrifice suffered in stability or accuracy of the device and minimal downtime of the equipment.

**Claims**

1. A transducer for monitoring power in a power line, said transducer including

a. current input means (44) for producing a current-representative signal proportional to the instantaneous current in the power line;

b. voltage input means (34) for producing a voltage-representative signal proportional to the instantaneous voltage on the power line;

c. multiplier means (20) connected to said current input means (44) and said voltage input means (34) for receiving said voltage representative signal and said current-representative signal the multiplier means including

(1) triangular wave generating means (18) including

  (a) squarewave generator (16) for producing a square waveform signal output on an output line and including a comparator means (56) and a resistive feedback means (60, 62) connecting said output line (86) of said squarewave generating means (16) to an input of the comparator means (56);

  (b) integrator means (24) connected to the output line (86) of the squarewave generating means (16) for producing a triangular wave signal,

(2) a pulse width modulator (32) connected to the triangular wave generating means (18) for combining said triangular wave signal with the voltage-representative signal, to produce a pulse train in which pulse width depends on the magnitude of the voltage representative signal,

(3) a pulse height modulator means (40) connected to said pulse width modulator (32) for modulating said pulse train by the current-representative signal so that the height of the pulses in said pulse train depends on the current-representative signal (46);

thereby producing a pulse train in which pulse area represents the power in the line;

d. filter and amplifying means (50) connected to the multiplier means (20) for filtering out alternating current components of the pulse train produced by the pulse height modulator (40) and integrating and amplifying the remaining direct current component thereof thereby producing a signal which is directly proportional to the instantaneous power in the power line;

characterised in that the squarewave generator (16) includes means for generating a first and a second reference voltage (64, 59, 68, 66, 58), and electronic switch (54) connected to be actuated by the output of the comparator means (56) to switch said output line (86) between the first or the second reference voltages, and there is provided amplifier means (28) connected to the output of the integrator means (24), said amplifier means (28) having an input (106) and a feedback means (108, 110, 126, 128, 130, 132), wherein the gain of said amplifier means (28) is adjusted by connecting the output of said amplifier means (28) to one of a number of points (126, 128, 130) in a resistive means (108) contained in said feedback means (108, 110, 126, 128, 130, 132) of said amplifier means (28).

2. A transducer according to claim 1 characterised in that the input of said integrator means (24) contains a resistive means (102) of high resistance for minimising any effect upon said triangular wave caused by variation of the output impedance of the squarewave generator (16).

3. A transducer according to claim 1 or 2 wherein said pulse height modulating means (40) is an electronic double-pole, double-throw switch (138, 140) the position of which is determined by the pulse train from said pulse width modulator (32), which positioning determines the circuit path taken within said switch by said current-representative signal whereby said output of said pulse height modulating means is said current-representative signal modulated by said output of said pulse width modulating means.

4. A transducer according to claim 1, 2 or 3 wherein said square waveform output of said squarewave generator (16) is at such a high frequency relative to an alternating signal which may pass upon the power line that those portions of said alternating signal sampled by said multiplier means (20) appear to be non-alternating signals, thereby rendering said multiplier means (20) capable of multiplying alternating signals as well as non-alternating signals.

**Patentansprüche**

1. Wandler zum Überwachen der in einer Starkstromleitung übertragenen Leistung, mit:

a. Einem Stromgeber (44) zum Erzeugen eines der Momentanstromstärke in der Starkstromleitung proportionalen Stromstärkesignals;

b. einem Spannungsgeber (34) zum Erzeugen eines der Momentanspannung an der Starkstromleitung proportionalen Spannungswertsignals;

c. einer mit dem Stromstärkegeber (44) und dem Spannungsgeber (34) verbundenen Multipliziereinrichtung (20), die das Spannungswertsignal und das Stromstärkesignal empfängt und folgende Teile umfaßt:

(1) einen Dreieckwellengenerator (18) mit

(a) einem zur Abgabe eines Rechteck-wellen-Ausgangssignals an eine Aus-gangsleitung dienenden Rechteckwell-engenerator (16) mit einem Vergleicher (56) und einer ohmschen Rückkopplungsschleife (60, 62), die die Ausgangsleitung (86) des Rechteckwellengenerators (16) mit einem Eingang des Vergleichers (56) verbindet;

(b) einem mit der Ausgangsleitung (86) des Rechteckwellengenerators (16) verbundenen Integrator (24) zum Erzeugen eines Dreieckwellensignals;

(2) einem mit dem Dreieckwellengenerator (18) verbundenen Impulsbreitenmodulator (32) zum Kombinieren des Dreieckwellensignals mit dem Spannungswertsignal derart, daß eine Impulsfolge erhalten wird, deren Impulsbreite von der Größe des Spannungswertsignals abhängt,

(3) einen mit dem Inpulsbreitenmodulator (32) verbundenen Impulshöhenmodulator (40) zum Modulieren des genannten Impulsfolge mit dem Stromstärkesignal derart, daß die Höhe der Impulse der Impulsfolge von dem Stromstärkesignal (46) abhängt; so daß eine Impulsfolge erzeugt wird, deren Impulsfläche der in der Leitung übertragenen Leistung entspricht;

d. eine mit der Multipliziereinrichtung (20) verbundene Filter- und Verstärkereinrichtung (50) zum Aussieben von Wechselstromkomponenten aus der von dem Impulshöhenmodulator (40) erzeugten Impulsfolge und zum Verstärken der verbleibenden Gleichstromkomponente derart, daß ein Signal erhalten wird, das dem Momentanwert der in der Starkstromleitung übertragenen Leistung direkt proportional ist;

dadurch gekennzeichnet, daß der Rechteckwellengenerator (16) eine Einrichtung (64, 59, 68, 66, 58) zum Erzeugen einer ersten und einer zweiten Bezugsspannung besitzt, ferner einen elektronischen Schalter (54), der so geschaltet ist, daß er in Abhängigkeit von dem Ausgangssignal des Vergleichers (56) die erste bzw. zweite Bezugsspannung an Ausgangsleitung (86) anlegt, und daß mit dem Ausgang des Integrators (24) ein Verstärker (28) verbunden ist, der einen Eingang (106) und eine Rückkopplungsschleife (108, 110, 126, 128, 130, 132) besitzt, und daß zum Einstellen des Verstärkungsfaktors des Verstärkers (28) dessen Ausgang mit einem Punkt einer Anzahl von Punkten (126, 128, 130) eines zu der Rückkopplungseinrichtung (108, 110, 126, 128, 130, 132) des Verstärkers (28) gehörenden Widerstandes (108) verbunden wird.

2. Wandler nach Anspruch 1, dadurch gekennzeichnet, daß der Eingang des Integrators (24) einen hochohmschen Widerstand (102) enthält, der dazu dient, den Einfluß von Veränderungen der Ausgangsimpedanz des Rechteckwellengenerators (16) auf die Dreieckwelle auf ein Minimum herabzusetzen.

3. Wandler nach Anspruch 1 order 2, dadurch gekennzeichnet, daß der Impulshöhenmodulator (40) ein zweipoliger, elektronischer Umschalter (138, 140) ist, dessen Stellung durch die von dem Impulsbreitenmodulator (32) abgegebenen Impulsfolge bestimmt wird und der durch seine Stellung den Leitweg bestimmt, auf dem das Stromstärkesignal in dem genannten Schalter geführt wird, so daß das Ausgangssignal des Impulshöhenmodulators das mit dem Ausgangssignal des Impulsbreitenmodulators modulierte Stromstärkesignal ist.

4. Wandler nach Anspruch 1, 2 oder 3, dadurch gekennzeichnet, daß die Frequenz des Rechteck-wellen-Ausgangssignals des Rechteckwellengen-erators (16) so viel höher ist als ein in der Starkstromleitung möglicherweise auftretendes, alternierendes Signal, daß die von der Multipliziereinrichtung (20) abgetasteten Teile dieses alternierenden Signals als nichtalternierende Signale erscheinen, so daß die Multipliziereinrichtung (20) geeignet ist, sowohl alternierende Signale als auch nichtalternierende Signale zu multiplizieren.

**Revendications**

1. Transducteur pour contrôler la pusissance dans une ligne d'alimentation en énergie, ledit transducteur comprenant

a. des moyens (44) d'introduction du courant servant à produire un signal représentatif du courant et proportionnel au courant instantané dans la ligne d'alimentation en énergie;

b. des moyens (34) d'introduction d'une tension servant à produire un signal représentatif de la tension et proportionnel à la tension instantanée présente dans la ligne d'alimentation en énergie;

c. des moyens multiplicateurs (20) raccordés auxdits moyens (44) d'introduction du courant et auxdits moyens (34) d'introduction de la tension afin de recevoir ledit signal représentatif de la tension et ledit signal représentatif du courant, les moyens multiplicateurs comprenant:

(1) des moyens (18) de production d'ondes triangulaires, comportant

(a) un générateur d'ondes carrées (16) servant à produire un signal de forme d'onde carrée délivré dans une ligne de sortie et comportant des moyens comparateurs (56) et des moyens de réaction résistive (60, 62) reliant ladite ligne de sortie (86) desdits moyens générateurs d'ondes carrées (16) à une entrée des moyens comparateurs (56);

(b) des moyens intégrateurs (24) raccordés à la ligne de sortie (86) des moyens générateurs d'ondes carrées (16) pour la production d'un signal d'onde triangulaire,

(2) un modulateur d'impulsions en durée (32) raccordé aux moyens générateurs d'ondes triangulaires (18) de manière à combiner ledit signal d'onde triangulaire au signal représentatif de la tension, en vue de produire un train d'impulsions dans lequel la durée des impulsions dépend de l'amplitude du signal représentatif de la tension,

(3) des moyens (40) formant modulateur d'impulsions en amplitude, raccordés audit modulateur d'impulsions en durée (32) pour moduler ledit train d'impulsions au moyen du signal représentatif du courant, de telle sorte que l'amplitude des impulsions dans ledit train d'impulsions dépend du signal (46) représentatif du courant;

ce qui fournit un train d'impulsions dans lequel la surface des impulsions représente la puissance présente dans la ligne;

d. des moyens (50) formant filtre et amplificateur, raccordés au moyens multiplicateurs (20) pour éliminer par filtrage les composantes de courant alternatif du train d'impulsions produit par le modulateur d'impulsions en amplitude (40) et pour intégrer et amplifier la composante de courant continu subsistante dudit train d'impulsions, en produisant de ce fait un signal qui est directement proportionnel à la puissance instantanée dans la ligne d'alimentation en énergie;

caractérisé en ce que le générateur d'ondes carrées (16) comprend des moyens servant à produire une première et une seconde tensions de référence (64, 59, 68, 66, 58), un commutateur électronique (54) raccordé de manière à être actionné par le signal de sortie des moyens comparateurs (56) afin de commuter ladite ligne de sortie (86) entre la première ou la seconde tension de référence, et qu'il est prévu des moyens amplificateurs (28) raccordés à la sortie des moyens intégrateurs (24), lesdits moyens amplificateurs (108, 110, 126, 128, 130, 132), le gain desdits moyens amplificateurs (28) étant réglé grâce au raccordement de la sortie desdits moyens amplificateurs (28) à un certain nombre de points (126, 128, 130) situés dans les moyens résistifs (108) que contiennent lesdits moyens de réaction (108, 110, 126, 128, 130, 132) desdits moyens amplificateurs (28).

2. Transducteur selon la revendication 1, caractérisé en ce que l'entrée desdits moyens intégrateurs (24) contient des moyens résistifs (102) possédant une résistance élevée, servant à réduire tout effet sur ladite onde triangulaire, produit par une variation de l'impédance de sortie du générateur d'ondes carrées (16).

3. Transducteur selon la revendication 1 ou 2, dans lequel lesdits moyens (40) de modulation d'impulsions en amplitudes sont constitués par un commutateur électronique bipolaire à deux directions (138, 140), dont la position est déterminée par le train d'impulsions délivré par ledit modulateur d'impulsions en durée (32), lequel positionnement détermine le trajet du circuit pris à l'intérieur dudit commutateur par ledit signal représentatif du courant, ce qui a pour effet que ledit signal de sortie desdits moyens de modulation d'impulsions en amplitude est ledit signal représentatif du courant, modulé par ledit signal de sortie desdits moyens de modulation d'impulsions en durée.

4. Transducteur selon la revendication 1, 2 ou 3, dans lequel ledit signal de sortie en forme d'onde carrée dudit générateur d'ondes carrées (16) possède, par rapport à un signal alternatif qui peut transiter dans la ligne d'alimentation en énergie, une fréquence élevée telle que les parties dudit signal alternatif, qui sont échantillonnées par lesdits moyens multiplicateurs (20), semblent être des signaux non alternatifs, ce qui rend lesdits moyens multiplicateurs (20) aptes à multiplier des signaux alternatifs ainsi que des signaux non alternatifs.

FIG. 1

0 049 520

# FIG. 2A

# FIG. 2B

0 049 520

FIG. 3

FIG. 4

4

# FIG. 5

FIG. 6

0 049 520